Europäisches Patentamt

(19) European Patent Office

Office européen des brevets

(11) Publication number: **0 019 381**
**B1**

(12) **EUROPEAN PATENT SPECIFICATION**

(45) Date of publication of patent specification: **09.01.91**

(51) Int. Cl.⁵: **G 11 C 17/00**

(21) Application number: **80301354.9**

(22) Date of filing: **24.04.80**

(54) Semiconductor memory device with address signal level setting.

(30) Priority: **27.04.79 JP 52125/79**

(43) Date of publication of application:
**26.11.80 Bulletin 80/24**

(45) Publication of the grant of the patent:
**09.01.91 Bulletin 91/02**

(84) Designated Contracting States:
**DE FR GB NL**

(56) References cited:
EP-A-0 018 774    US-A-3 611 318
EP-A-0 098 215    US-A-3 898 630
US-A-3 588 851    US-A-4 424 582

SIEMENS FORSCHUNGS-UND
ENTWICKLUNGSBERICHTE, vol.4, no.4, 1975,
Springer-Verlag,Berlin DE MURMANN &
SCHARBERT: "A high speed 1024-bit ECL
programmable read-only memory", pages 245-
249.

IBM TECHNICAL DISCLOSURE BULLETIN, vol 21
no. 1 June 1978, pages 105-108, New York USA
RADCLIFFE: "Fusable diode array circuits".

(73) Proprietor: **FUJITSU LIMITED**
**1015, Kamikodanaka Nakahara-ku**
**Kawasaki-shi Kanagawa 211 (JP)**

(72) Inventor: **Fukushima, Toshitaka**
**1604-442, Shiomidai**
**Isogo-ku Yokohama-shi Kanagawa (JP)**
Inventor: **Koyama, Kazumi**
**3-17-7, Wakabadai**
**Shiroyama-cho Tsukui-gun Kanagawa (JP)**
Inventor: **Ueno, Kouji**
**1360, Shukugawara**
**Tama-ku Kawasaki-shi Kanagawa (JP)**
Inventor: **Miyamura, Tamio**
**1381, Ida**
**Nakahara-ku Kawasaki-shi Kanagawa (JP)**
Inventor: **Kawabata, Yuichi**
**708, Kashimada**
**Saiwai-ku Kawasaki-shi Kanagawa (JP)**

(74) Representative: **George, Sidney Arthur et al**
**GILL JENNINGS & EVERY 53-64 Chancery Lane**
**London WC2A 1HN (GB)**

## Description

This invention relates to a semiconductor memory device, and more specifically to a decoder circuit of a semiconductor memory device which writes information by causing memory cells such as PROM (programmable read-only memories) to be conductive (short-circuited) or non-conductive (open-circuited).

A programmable read-only memory usually consists of address inverters, decoders, memory cells, multiplexers, output buffers and a programming circuit. The memory cells are of the junction type in which the emitter-base junctions are connected to intersecting points of word lines and bit lines so that the junctions are short-circuited by the heat generated by a writing current. Alternatively they are of the fusing type in which a vaporized metal or polycrystalline silicon is melted and cut by the writing current.

With such semiconductor memory devices, the address inverters, the memory cells, the decoder circuits, the multiplexers and the output buffers must be simplified and reduced in size with increase in the memory capacity.

A semiconductor memory device which employs a programmable read-only memory cell operates with greatly differing writing and reading currents. For example, these currents may be 200 mA and 0.5 mA, respectively. In such a programmable read-only memory, if a current which is sufficient to produce a writing current is fed to the base of a transistor which provides a reading current when the information is being read out, the transistor will be saturated and electric charges will accumulate in the base. Therefore, an extended period of time is required to render the transistor non-conductive. Hence, the circuit is not suited for high-speed operation.

In order to prevent this problem, a conventional decoder circuit has been employed which uses a feedback circuit having a diode to supply a suitable base current to the above-mentioned transistor when information is to be written-in and read-out (see "Electronics Digest", "Practical Application of IC Memory PROM", pages 2—7, August 1974, published in Japan). This known semiconductor device comprises a plurality of memory cells which are accessed for writing or reading data by selectively addressing word and bit lines coupled thereto; a programming circuit operable to write a data item into a selected memory cell by passing a relatively high current through the associated bit line, the memory cell the associated word line and an output transistor of an address decoder, whereby the memory cell is rendered permanently conductive or permanently non-conductive; a circuit for reading a data item from a selected conductive memory cell by passing a relatively low current through the associated bit line, the memory cell, the associated word line and the associated output transistor; a respective driver transistor for feeding base current to each output transistor; a power supply input for the driver and output transistors;

and means to cause a higher base current to flow in a selected output transistor during writing than during reading;

However, provision of the feedback circuit makes the wiring complicated and it is undesirable from the standpoint of highly integrating the circuits. Furthermore, the feedback circuit is not adequate to allow high-speed operation.

According to this invention in such a device the means to cause a higher base current to flow during writing comprises injection means to inject only into the collector circuit of the driver transistor during writing a voltage which is higher than the voltage of the power supply.

An embodiment of the invention will now be described, by way of example, with reference to the accompanying drawings, in which:

Fig. 1 is a block diagram of a conventional semiconductor memory device;

Fig. 2 is a circuit diagram of a conventional semiconductor memory device;

Fig. 3 is a circut diagram of a semiconductor memory device according to the present invention, and especially a decoder circuit, and

Fig. 4 is a circuit diagram of a circuit for providing a current to feed driving current to transistors of a decoder driver in a semiconductor memory device according to the present invention.

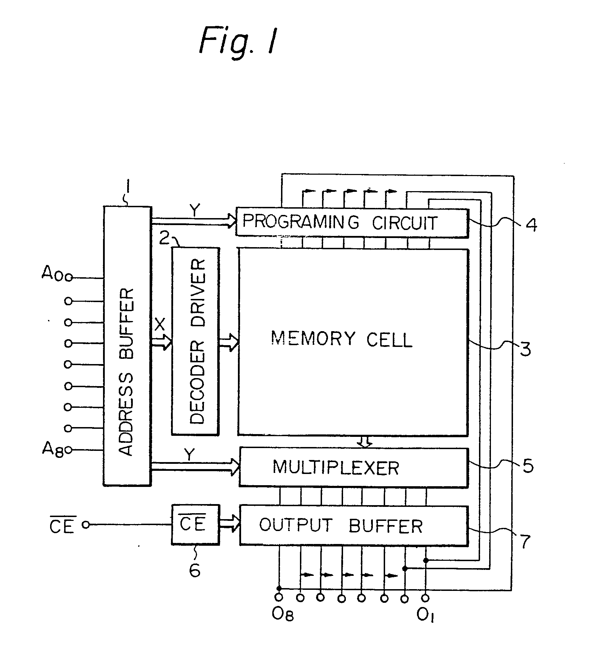

Referring to Fig. 1, a conventional programmable read-only memory comprises an address buffer 1 which receives address signals $A_0$ to $A_8$, a decoder driver 2 which decodes the output of the address buffer 1, memory cells 3, a programming circuit 4 which provides information in the Y direction of the address buffer 1 and which feeds an output to the memory cells 3, a multiplexer 5 which provides information in the Y direction of the memory cells 3, a $\overline{CE}$ (chip enable) circuit 6 which provides chip enable signals, and an output buffer 7 which receives the output of the $\overline{CE}$ circuit as well as the content of the multiplexer 5.

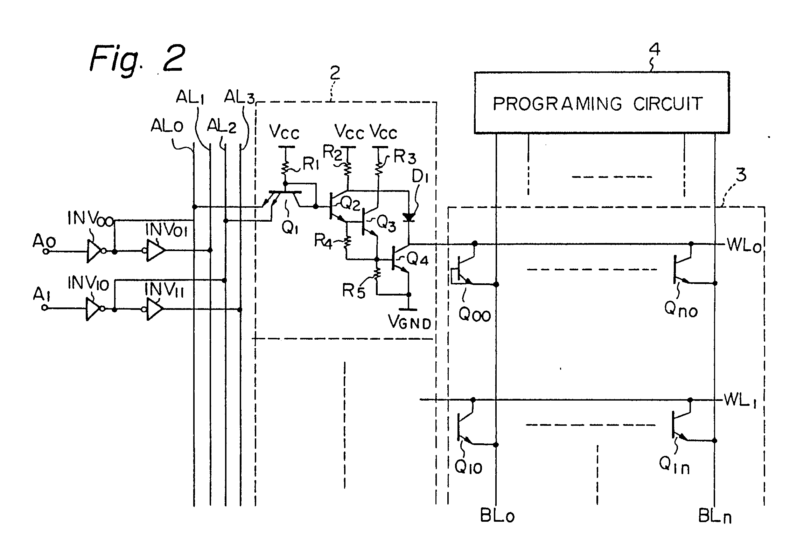

Fig. 2 is a partial circuit diagram of a conventional semiconductor memory device, in particular of a junction-type programmable read-only memory.

In Fig. 2, symbols $INV_{00}$ to $INV_{11}$ denote address inverters, $AL_0$ to $AL_3$ denote address signal lines, 2 is a decoder driver circuit, $Q_1$ to $Q_4$ are transistors, $R_1$ to $R_5$ are resistors, $D_1$ is a diode, 4 is a programming circuit, 3 is a memory cell unit, $Q_{00}$ to $Q_{1n}$ are memory cells, $WL_0$, $WL_1$—are word lines, and $BL_0$ to $BL_n$ are bit lines.

The writing operation of the circuit is described below in relation to the case where information is to be written in by short-circuiting the emitter-base junction of a memory cell $Q_{00}$ in the memory cell unit 3.

When address signals are fed to input terminals $A_0$ and $A_1$ of the inverters $INV_{00}$ and $INV_{10}$, the address signal lines $AL_0$ to $AL_3$ are set to levels which correspond to the signal levels fed to the input terminals $A_0$ to $A_1$.

Namely, when the terminal $A_0$ and the terminal $A_1$ both assume low levels, the address signal line

$AL_0$ assumes a high level, the address signal line $Al_1$ assumes a low level, the address signal line $AL_2$ assumes a high level, and the address signal line $AL_3$ assumes a low level. The emitters of a multiple-emitter transistor $Q_1$ of a decoder driver which is connected to the word line $WL_0$ are connected to the address signal lines $AL_0$ and $AL_2$. Therefore, the transistor $Q_1$ is rendered non-conductive, and a base current is supplied from a power supply $V_{CC}$ to the transistor $Q_2$ via the resistor $R_1$. Accordingly, the transistor $Q_2$ is rendered conductive, and the transistors $Q_3$ and $Q_4$ are also rendered conductive to select the word line $WL_0$. In this case, a writing current of about 200 mA is supplied to the memory cell $Q_{00}$ via a path $BL_0$, $Q_{00}$, $Q_4$, $V_{GND}$ to short-circuit the emitter-base junction of the memory cell $Q_{00}$. In the writing state, the base current of the transistor $Q_4$, which must carry a writing current of about 200 mA, is supplied through the transistors $Q_2$ and $Q_3$ of the decoder circuit.

Next, the reading operation of the circuit is described below with reference to the memory cell $Q_{00}$ in which the emitter-base junction is now assumed to be short-circuited.

Information can be read out by detecting whether or not a current flows into the transistor $Q_4$ through the memory cell $Q_{00}$. When a low level voltage is applied to the terminals $A_0$ and $A_1$, the word line $WL_0$ is selected whereby the transistor $Q_1$ is rendered non-conductive and the transistors $Q_2$, $Q_3$ and $Q_4$ are rendered conductive, in the same manner as is described above for the writing state. In the reading state, there is no need to apply such a large current as is applied in the above-mentioned writing state. A reading current of about 0.5 mA, which is two or three orders smaller than the writing current, flows into the bit line $BL_0$ and the word line $WL_0$ thorough a path $BL_0$, $Q_{00}$, $Q_4$, $V_{GND}$.

In the writing state, a current of about 200 mA flows through the transistor $Q_4$, the collector potential of the transistor $Q_4$ is sustained high, and the diode $D_1$ is rendered non-conductive, whilst in reading state a small current of about 0.5 mA is sunk in the transistor $Q_4$. Therefore, the collector potential of the transistor $Q_4$ is sustained low, and, as a result, the diode $D_1$ is rendered conductive. A base current of the transistor $Q_2$, which is supplied from the power supply $V_{CC}$ via the resistor $R_1$, is divided into an emitter current and a collector current. Accordingly, the base current supplied to the transistor $Q_3$ is smaller than that which is supplied when information is being written in. Hence, the base current of the transistor $Q_4$ becomes so small that a current of about 0.5 mA is drawn from the word line $WL_0$.

Conventionally, in the programmable read-only memory in which the writing current and the reading current have such greatly different values as 200 mA and 0.5 mA, if the base current of the transistor $Q_4$ is so great as to be capable of driving the writing current of 200 mA even in the reading state, the transistor $Q_4$ becomes saturated due to excessive base current, and an excessive electric charge accumulates in the base. Hence, the transistor $Q_4$ takes a long time to turn off and is therefore not suited to high-speed operation. In order to prevent the above-mentioned inconvenience, therefore, the conventional decoder circuit has been equipped with a feedback circuit which switches the base current of the transistor $Q_4$, so that suitable base currents can be supplied to the transistor $Q_4$ in both the writing and reading states. However, provision of the feedback circuit makes the circuit arrangement complicated, and is not desirable from the standpoint of producing highly integrated circuits. For example, as will be obvious from Fig. 2, the collector of the transistor $Q_2$ and the collector of the transistor $Q_4$ in the feedback circuit must be connected via the diode $D_1$ which crosses the wiring of the transistor $Q_3$, thus making the wiring complicated.

Instead of providing a feedback circuit, it would theoretically be possible to switch between low and high voltage power supplies, depending upon whether reading or writing is to be effected as disclosed in an article by Murrmann & Scharbert published in "Siemens Forschungs- und Entwiclungsbereichte" vol. 4, No. 4, 1975 at pages 245—249. However problems would result from the use of this method, because the power supply would apply the increased voltage not only to the decoder circuit but also to the other circuits of the memory device. The increased voltage could act against the design requirements of those other circuits.

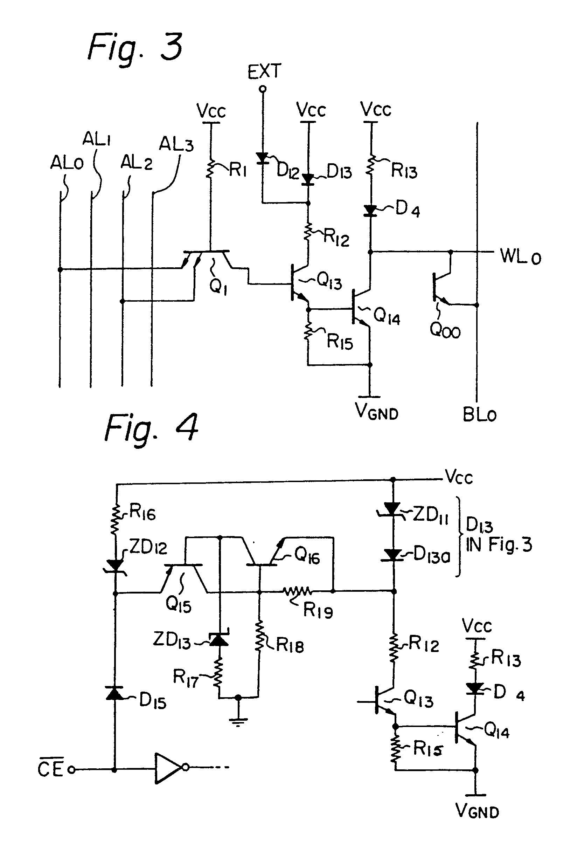

An embodiment of the present invention will now be described with reference to Fig. 3, which illustrates a decoder driver circuit, an address signal line and a word line. Although they are not shown, the circuit of Fig. 3 is connected to address inverters and a programming circuit as illustrated in Figure 2. In the present invention, the feedback circuit of Figure 2, which comprises the transistor $Q_2$ and the diode $D_1$, is eliminated and, instead, an external terminal EXT is connected to the collector of a transistor $Q_{13}$ to control the base current of the transistor $Q_{14}$ in the final stage. In addition, a resistor $R_{13}$ and a dide $D_4$ for preventing current from flowing towards the power supply $V_{CC}$ are connected in series to the collector of the output transistor $Q_{14}$.

During writing, a voltage which is greater than the power supply voltage $V_{CC}$ (of, for example, 5 volts) is applied to the terminal EXT, whereby a base current which is large enough to pass a current of about 200 mA from the word line $WL_0$ is fed to the transistor $Q_{14}$ via the transistor $Q_{13}$. The diode $D_{13}$ is provided to prevent the current which is applied from the terminal EXT from flowing to the supply voltage $V_{CC}$.

During reading, on the other hand, an input voltage less than or equal to the supply voltage is applied to the terminal EXT. In this case, the transistor $Q_{14}$ is driven by a base current consisting of a current which flows from the power supply $V_{CC}$ via $R_1$ and $Q_1$ and a current which flows from the power supply $V_{CC}$ via $R_{12}$, $D_{13}$ and $Q_{13}$. The base current of the transistor $Q_{14}$ is small

enough to sink a reading current of about 0.5 mA from the word line $WL_0$. The diode $D_{12}$ is provided to prevent the collector current, which is supplied by the supply voltage $V_{CC}$, from flowing to the terminal EXT.

Hence, by supplying a base current from an external terminal to the transistor $Q_{14}$ in the final stage, the base current of the transistor can be controlled in both the reading and writing states, and hence the feedback circuit which requires complicated cross-over wiring illustrated in the conventional circuit can be eliminated. Moreover, by supplying enough base current from the terminal EXT, there is no need to increase the number of stages to amplify the base current, i.e. the number of stages can be reduced and the circuit can be simplified.

An alternative circuit for supplying the increased base current is described now in detail with reference to Fig. 4. As illustrated in Fig. 4, the collector circuit of the transistor $Q_{13}$ can be connected to the chip enable input $\overline{CE}$ through a voltage control circuit. When information is to be written into a memory cell, a signal source applies a relatively high voltage to the terminal $\overline{CE}$, and when information is to be read from the memory cell a lower voltage is applied to the terminal $\overline{CE}$. The control circuit comprises a diode $D_{15}$ connected to the terminal $\overline{CE}$, a series circuit comprising a zener diode $ZD_{12}$ and a resistor $R_{16}$ connected between the power supply $V_{CC}$ and the diode $ZD_{12}$, a transistor $Q_{15}$ of which the emitter is connected to the junction of the diode $D_{15}$ and the zener diode $ZD_{12}$, a series circuit comprising a zener diode $ZD_{13}$ and a resistor $R_{17}$ connected between the base of the transistor $Q_{15}$ and ground, a transistor $Q_{16}$ the base of which is connected to the collector of the transistor $Q_{15}$, and the collector of which is connected to the base of the transistor $Q_{15}$. A resistor $R_{19}$ is connected between the base and the emitter of the transistor $Q_{16}$. The base is served with the collector voltage of the transistor $Q_{15}$. A resistor $R_{18}$ to prevent the voltage control circuit from malfunctioning due to surge current is connected between the base of the transistor $Q_{16}$ and ground. A series circuit comprising a zener diode $ZD_{11}$ and a diode $D_{13a}$ is connected between the power supply $V_{CC}$ and the junction of the emitter of the transistor $Q_{16}$, the resistor $R_{19}$ and the resistor $R_{12}$.

In the circuit of Fig. 4, the diode $D_{15}$, acts to prevent reverse current flow, and the zener diode $ZD_{12}$ and the resistor $R_{16}$ act to reduce the input capacitance.

The series circuit of the zener diode $ZD_{13}$ and the resistor $R_{17}$ give inclination to the voltage-current characteristics, and the resistor $R_{18}$ prevents the transistors $Q_{15}$ and $Q_{16}$ from being rendered conductive by a surge current. Resistor $R_{13}$ and diode $D_4$ are connected in series between the power supply $V_{CC}$ and the collector of the output transistor to prevent current flow towards the power supply $V_{CC}$.

The transistors $Q_{15}$ and $Q_{16}$ form an SCR circuit.

The zener diode $ZD_{13}$ is connected to the base of the transistor $Q_{15}$. Hence, when a voltage greater than the reference voltage of the zener diode $ZD_{13}$ is applied to the terminal $\overline{CE}$, the transistor $Q_{15}$ is rendered conductive and a collector current flows. As the collector current flows into the transistor $Q_{15}$, the base potential of the transistor $Q_{16}$ is raised, so that the transistor $Q_{16}$ is rendered conductive. Accordingly, the transistor $Q_{13}$ supplies a base current to the transistor $Q_{14}$ so that it will be capable of sinking a write current of about 200 mA. In Fig. 4, the series circuit comprising the zener diode $ZD_{11}$ and the diode $D_{13a}$ is equivalent to the diode $D_{13}$ of Fig. 3.

In the present invention described in the foregoing, the decoder circuit does not require a feedback circuit for switching the base current of the transistor in the final stage from a reading state to a writing state and vice versa. Hence, the circuit configuration and wiring can be simplified and the mask for manufacting the device can be simplified, making it possible to form a semiconductor memory device having a high degree of integration.

Although a chip enable terminal was used for supplying the increased base current in the described embodiment, it would be allowable to use an address input terminal to which can be applied a voltage (of, for example, 20 volts) which is greater than that of the power supply $V_{CC}$.

**Claims**

1. A semiconductor memory device, comprising a plurality of memory cells ($Q_{00}$, $Q_{10}$ ...) which are accessed for writing or reading data by selectively addressing word and bit lines ($WL_0$, $WL_1$ ...; $BL_0$—$BL_n$) coupled thereto a programming circuit (4) operable to write a data item into a selected memory cell by passing a relatively high current through the associated bit line, the memory cell the associated word line and an associated output transistor ($Q_{14}$) of an address decoder (2), whereby the memory cell is rendered permanently conductive or permanently non-conductive; a circuit (5) for reading a data item from a selected conductive memory cell by passing a relatively low current through the associated bit line, the memory cell, the associated word line and the associated output transistor; a respective driver transistor ($Q_{13}$) for feeding base current to each output transistor ($Q_{14}$); a power supply ($V_{CC}$) connected to the collector circuits of the driver and output transistors; and means to cause a higher base current to flow in a selected output transistor during writing than during reading; characterised in that the means to cause a higher base current to flow during writing comprises injection means (EXT, $D_{12}$; $\overline{CE}$, $Q_{15}$, $Q_{16}$, $ZD_{13}$) to inject only into the collector circuit of the driver transistor ($Q_{13}$) during writing a voltage which is higher than the voltage of the power supply.

2. A semiconductor memory device according to claim 1, in which the injection means comprises a first diode ($D_{13}$) connected between the

power supply ($V_{CC}$) and a first resistor ($R_{12}$) in the collector circuit of the driver transistor ($Q_{13}$) for preventing current from flowing towards the power supply ($V_{CC}$); a terminal (EXT) connected via a scond diode ($D_{12}$) to the connection point of the first diode ($D_{13}$) and the first resistor ($R_{12}$) in the collector circuit of the driver transistor ($Q_{13}$), to which terminal (EXT) a voltage larger than that of the power supply ($V_{CC}$) is supplied during a writing operation as compared with that during a reading operation; and second means ($R_{13}$, $D_4$) comprising a further resistor ($R_{13}$) and a further diode ($D_4$) for preventing current from flowing towards the power supply ($V_{CC}$) in the collector circuit of the output transistor ($Q_{14}$).

3. A semiconductor memory device according to claim 1, including a control input $\overline{(CE)}$ to which a control voltage is applied for reading data from the device, and in which the injection means includes a voltage sensitive switch ($Q_{15}$, $Q_{16}$, $ZD_{13}$) which is coupled between the control input $\overline{(CE)}$ and the collector circuit of the driver transistor ($Q_{13}$) and which is operative, in response to application to the control input $\overline{(CE)}$ of a voltage above a threshold level which is higher than the control voltage used for reading data, to inject into the collector circuit of the driver transistor ($Q_{13}$) a voltage which is higher than the voltage of the power supply ($V_{CC}$).

4. A semiconductor memory device according to claim 3, in which the injection means also includes a first diode ($D_{13}$; $D_{13a}$) connected between the power supply ($V_{CC}$) and a first resistor ($R_{12}$) in the collector circuit of the driver transistor ($Q_{13}$) for preventing current from flowing towards the power supply ($V_{CC}$); the voltage sensitive switch ($Q_{15}$, $Q_{16}$, $ZD_{13}$) being connected to the connection point of the first diode ($D_{13}$; $D_{13a}$) and the first resistor ($R_{12}$) in the collector circuit of the driver transistor ($Q_{13}$); and means ($R_{13}$, $D_4$) comprising a second resistor ($R_{13}$) and a second diode ($D_4$) for preventing current from flowing towards the power supply ($V_{CC}$) in the collector circuit of the output transistor ($Q_{14}$).

5. A semiconductor memory device according to claim 3 or 4, in which the voltage sensitive switch comprises a first transistor ($Q_{15}$) the emitter of which is connected to the control input $\overline{(CE)}$; a series circuit comprising a zener diode ($ZD_{13}$) and a resistor ($R_{17}$) connected between the base of the first transistor ($Q_{15}$) and ground; a second transistor ($Q_{16}$) the base of which is connected to the collector of the first transistor ($Q_{15}$) and the collector of which is connected to the base of the first transistor ($Q_{15}$); a resistor ($R_{19}$) connected between the base and the emitter of the second transistor ($Q_{16}$), and which receives the collector voltage of the first transistor ($Q_{15}$); and a resistor ($R_{18}$) connected between the base of the second transistor ($Q_{16}$) and ground to prevent the circuit from malfunctioning due to surge current.

6. A semiconductor memory device according to any one of claims 3, 4 or 5, in which a diode ($D_{15}$) for preventing reversal of current flow is connected between the control input $\overline{(CE)}$ and the voltage sensitive switch ($Q_{15}$, $Q_{16}$, $ZD_{13}$); and in which a series circuit of a resistor ($R_{16}$) and a zener diode ($ZD_{12}$) for preventing an increase in capacitance is connected between the power supply ($V_{CC}$) and the junction between the voltage sensitive switch ($Q_{15}$, $Q_{16}$, $ZD_{13}$) and the current reversal-preventing diode ($D_{15}$).

7. A semiconductor memory device according to any one of claims 3 to 6, in which the voltage above a threshold level is a voltage from a signal source which generates a chip enable signal during a writing operation.

8. A semiconductor memory device according to any one of claims 3 to 7, in which the higher voltage injected only into the collector circuit of the driver transistor ($Q_{13}$) is the voltage applied to the control input $\overline{(CE)}$.

**Patentansprüche**

1. Halbleiterspeichervorrichtung mit einer Vielzahl von Speicherzellen ($Q_{00}$, $Q_{10}$ ...), zu denen zum Schreiben oder zum Lesen von Daten durch selektives Adressieren von mit ihnen verbundenen Wort- und Bitleitungen ($WL_0$, $WL_1$ ...; $BL_0$—$BL_n$) zugegriffen wird, mit einer Programmierschaltung (4), die betreibbar ist, um einen Datenwert in eine ausgewählte Speicherzelle einzuschreiben, indem ein relativ hoher Strom durch die zugeordnete Bitleitung, die Speicherzelle, die zugeordnete Wortleitung und einen zugeordneten Ausgangstransistor ($Q_{14}$) eines Adressdecoders (2) geschickt wird, wodurch die Speicherzelle permanent leitend oder permanent nichtleitend wird; einer Schaltung (5) zum Lesen eines Datenwertes von einer ausgewählten leitenden Speicherzelle, indem ein relativ niedriger Strom durch die zugeordnete Bitleitung, die Speicherzelle, die zugeordnete Wortleitung und den zugeordneten Ausgangstransistor geschickt wird; einem entsprechenden Treibertransistor ($Q_{13}$) zum Zuführen eines Basisstromes zu jedem Ausgangstransistor ($Q_{14}$); einer Energieversorgung ($V_{CC}$), die mit den Kollektorschaltungen der Treiber- und Ausgangstransistoren verbunden ist; und einer Einrichtung, die bewirkt, daß während des Schreibens ein höherer Basisstrom in einem ausgewählten Ausgangstransistor fließt als während des Lesens; dadurch gekennzeichnet, daß die Einrichtung zur Verursachung eines höheren Basisstromflusses während des Schreibens eine Injektionseinrichtung (EXT, $D_{12}$; $\overline{CE}$, $Q_{15}$, $Q_{16}$, $ZD_{13}$) umfaßt, um während des Schreibens nur in die Kollektorschaltung des Treibertransistors ($Q_{13}$) eine Spannung zu injizieren, die höher als die Spannung der Energieversorgung ist.

2. Halbleiterspeichervorrichtung nach Anspruch 1, bei der die Injektionseinrichtung eine erste Diode ($D_{13}$) umfaßt, die zwischen der Energieversorgung ($V_{CC}$) und einem ersten Widerstand ($R_{12}$) in der Kollektorschaltung des Treibertransistors ($Q_{13}$) verbunden ist, um zu verhindern, daß Strom zu der Energieversorgung ($V_{CC}$) fließt; einen Anschluß (EXT), der über eine zweite Diode ($D_{12}$) mit dem Verbindungspunkt der ersten Diode

($D_{13}$) und des ersten Widerstands ($R_{12}$) in der Kollektorschaltung des Treibertransistors ($Q_{13}$) verbunden ist, welchem Anschluß (EXT) während eines Schreibbetriebes eine Spannung größer als jene der Energieversorgung ($V_{CC}$) zugeführt wird, im Vergleich mit derjenigen während eines Lesebetriebs; und eine zweite Einrichtung ($R_{13}$, $D_4$), die einen weiteren Widerstand ($R_{13}$) und eine weitere Diode ($D_4$) zur Verhinderung eines Stromflusses zu der Energieversorgung ($V_{CC}$) in der Kollektorschaltung des Ausgangstransistors ($Q_{14}$) umfaßt.

3. Halbleiterspeichervorrichtung nach Anspruch 1, mit einem Steuereingang ($\overline{CE}$), dem zum Lesen von Daten von der Einrichtung eine Steuerspannung zugeführt wird, und bei der die Injektionseinrichtung einen spannungsempfindlichen Schalter ($Q_{15}$, $Q_{16}$, $ZD_{13}$) umfaßt, der zwischen dem Steuereingang ($\overline{CE}$) und der Kolektorschaltung des Treibertransistors ($Q_{13}$) angeschlossen ist und in Abhängigkeit von der Anwendung einer Spannung oberhalb eines Schwellenwertpegels, der höher als die Steuerspannung ist, die zum Lesen von Daten verwendet wird, auf den Steuereingang ($\overline{CE}$) wirksam ist, um in die Kollektorschaltung des Treibertransistors ($Q_{13}$) eine Spannung zu injizieren, die höher als die Spannung der Energieversorgung ($V_{CC}$) ist.

4. Halbleiterspeichervorrichtung nach Anspruch 3, bei der die Injektionseinrichtung ferner eine erste Diode ($D_{13}$; $D_{13a}$) enthält, die zwischen der Energieversorgung ($V_{CC}$) und einem ersten Widerstand ($R_{12}$) in der Kollektorschaltung des Treibertransistors ($Q_{13}$) verbunden ist, um zu verbindern, daß Strom zu der Energieversorgung ($V_{CC}$) fließt; einen spannungsempfindlichen Schalter ($Q_{15}$, $Q_{16}$, $ZD_{13}$), der mit dem Verbindungspunkt der ersten Diode ($D_{13}$; $D_{13a}$) und dem ersten Widerstand ($R_{12}$) in der Kollektorschaltung des Treibertransistors ($Q_{13}$) verbunden ist; und Einrichtungen ($R_{13}$, $D_4$), die einen zweiten Widerstand ($R_{13}$) und eine zweite Diode ($D_4$) in der Kollektorschaltung des Ausgangstransistors ($Q_{14}$) zum Verhindern eines Stromflusses zu der Energieversorgung ($V_{CC}$) umfassen.

5. Halbleiterspeichervorrichtung nach Anspruch 3 oder 4, bei der der spannungsempfindliche Schalter einen ersten Transistor ($Q_{15}$) umfaßt, dessen Emitter mit dem Steuereingang ($\overline{CE}$) verbunden ist; eine Reihenschaltung, die eine Zenerdiode ($ZD_{13}$) und einen Widerstand ($R_{17}$) umfaßt, die zwischen der Basis des ersten Transistors ($Q_{15}$) und Erde verbunden ist; einen zweiten Transistor ($Q_{16}$), dessen Basis mit dem Kollektor des ersten Transistors ($Q_{15}$) verbunden ist, und dessen Kollektor mit der Basis des ersten Transistors ($Q_{15}$) verbunden ist; einen Widerstand ($R_{19}$), der zwischen der Basis und dem Emitter des zweiten Transistors ($Q_{16}$) verbunden ist, und der die Kollektorspannung des ersten Transistors ($Q_{15}$) empfängt; und einen Widerstand ($R_{18}$), der zwischen der Basis des zweiten Transistors ($Q_{16}$) und Erde verbunden ist, um zu verhindern, daß die Schaltung aufgrund von Stromstößen fehlerhaft arbeitet.

6. Halbleiterspeichervorrichtung nach einem der Ansprüche 3, 4 oder 5, bei der eine Diode ($D_{15}$) zur Verhinderung einer Umkehr des Stromflusses zwischen dem Steuereingang ($\overline{CE}$) und dem spannungsempfindlichen Schalter ($Q_{15}$, $Q_{16}$, $ZD_{13}$) verbunden ist; und bei der eine Reihenschaltung aus einem Widerstand ($R_{16}$) und einer Zenerdiode ($ZD_{12}$) zur Verhinderung einer Zunahme der Kapazität zwischen der Energieversorgung ($V_{CC}$) und dem Verbindungspunkt zwischen dem spannungsempfindlichen Schalter ($Q_{15}$, $Q_{16}$, $ZD_{13}$) und der Stromumkehrverhinderungsdiode ($D_{15}$) verbunden ist.

7. Halbleiterspeichervorrichtung nach einem der Ansprüche 3 bis 6, bei der die Spannung oberhalb eines Schwellenwertpegels eine Spannung von einer Signalquelle ist, welche während eines Schreibprozesses ein Chipfreigabesignal erzeugt.

8. Halbleiterspeichervorrichtung nach einem der Ansprüche 3 bis 7, bei der die höhere Spannung, die nur in die Kollektorschaltung des Treibertransistors ($Q_{13}$) injiziert wird, die Spannung ist, die dem Steuereingang ($\overline{CE}$) zugeführt wird.

## Revendications

1. Composant mémoire à semi-conducteur, comprenant une pluralité de cellules mémoires ($Q_{00}$, $Q_{10}$ ...) auxquelles on accède en écriture et lecture de données en adressant sélectivement des lignes bit et mot ($WL_0$, $WL_1$ ...; $BL_0$—$BL_n$) qui y sont couplées; un circuit de programmation (4) capable d'écrire un élément de donnée dans une cellule mémoire sélectionnée en transmettant un courant relativement élevé dans: la ligne bit associée, la cellule mémoire, la ligne mot associée et un transistor de sortie associé ($Q_{14}$) d'un décodeur d'adresse (2), ce qui rend la cellule mémoire conductrice de façon permanente ou non-conductrice de façon permanente; un circuit (5) de lecture d'un élément de donnée à partir d'une cellule mémoire conductrice sélectionnée en transmettant un courant relativement bas par la ligne bit associée, la cellule mémoire, la ligne mot associée et le transistor de sortie associé; un transistor de commande respectif ($Q_{13}$) d'alimentation en courant de base de chaque transistor de sorte ($Q_{14}$); une source d'alimentation ($V_{CC}$) reliée aux circuits de collecteur des transistors de commande et de ceux de sortie; et des moyens pour faire passer un courant de base, dans un transistor de sortie sélectionné, qui soit plus élevée pendant l'écriture que pendant la lecture; caractérisé en ce que les moyens pour faire passer un courant de base plus élevé pendant l'écriture comprennent des moyens d'injection (EXT, $D_{12}$; $\overline{CE}$, $Q_{15}$, $Q_{16}$, $ZD_{13}$) pour injecter seulement dans le circuit de collecteur du transistor de commande ($Q_{13}$) pendant l'écriture une tension qui est plus élevée que la tension de la source d'alimentation.

2. Composant mémoire à semi-cnducteur selon la revendication 1, dans lequel les moyens d'injection comprennent un première diode ($D_{13}$) branchée entre la source d'alimentation ($V_{CC}$) et une première résistance ($R_{12}$) dans le circuit de collecteur du transistor de commande (Q₁₃) pour éviter que le courant ne passe vers la source d'alimentation (V_CC); une broche (EXT) reliée via une seconde diode (D₁₂) au point de connexion de la première diode (D₁₃) et de la première résistance (R₁₂) dans le circuit de collecteur du transistor de commande (Q₁₃), broche (EXT) à laquelle une tension supérieure à celle de la source d'alimentation (V_CC) est fournie pendant une opération d'écriture, en comparaison à celle pendant une opération de lecture; et des seconds moyens (R₁₃, D₄) comprenant une autre résistance (R₁₃) et une autre diode (D₄) pour éviter que le courant ne passe vers la source d'alimentation (V_CC) dans le circuit de collecteur du transistor de sortie (Q₁₄).

3. Composant mémoire à semi-conducteur selon la revendication 1, comprenant une entrée de commande $\overline{CE}$ à laquelle est appliquée une tension de commande pour la lecture de données dans composant, et dans lequel les moyens d'injection comprennent un commutateur sensible à la tension (Q₁₅, Q₁₆, ZD₁₃) qui est branché entre l'entrée de commande (CE) et le circuit de collecteur du transistor de commande (Q₁₃) et qui sert, en réponse à l'application sur l'entrée de commande $\overline{CE}$ d'une tension au-dessus d'un niveau de seuil qui est supérieur à celui de la tension de commande utilisée pour lire les données, à injecter dans le circuit de collecteur du transistor de commande (Q₁₃) une tension qui est plus élevée que la tension de la source d'alimentation (V_CC).

4. Composant mémoire à semi-conducteur selon la revendication 3, dans lequel les moyens d'injection comprennent aussi une première diode (D₁₃; D₁₃ₐ) branchée entre la source d'alimentation (V_CC) et une première résistance (R₁₂) dans le circuit de collecteur du transistor de commande (Q₁₃) pour éviter que le courant ne passe vers la source d'alimentation (V_CC); le commutateur sensible à la tension (Q₁₅, Q₁₆, ZD₁₃) étant branché au point de connexion de la première diode (D₁₃; D₁₃ₐ) et de la première résistance (R₁₂) dans le circuit de collecteur du transistor de commande (Q₁₃); et des moyens (R₁₃, D₄) comprenant une seconde résistance (R₁₃) et une seconde diode (D₄) pour éviter que le courant ne passe vers la source d'alimentation (V_CC) dans le circuit de collecteur du transistor de sortie (Q₁₄).

5. Composant mémoire à semi-conducteur selon la revendication 3 ou 4, dans lequel le commutateur sensible à la tension comprend un premier transistor (Q₁₅) dont l'émetteur est relié à l'entrée de commande $\overline{CE}$; un circuit série comprenant une diode zéner (ZD₁₃) et une résistance (R₁₇) branché entre la base du premier transistor (Q₁₅) et la masse; un second transistor Q₁₆) dont la base est reliée au collecteur du premier transistor (Q₁₅) et dont le collecteur est relié à la base du premier transistor (Q₁₅); une résistance (R₁₉) branchée entre la base et l'émetteur du second transistor (Q₁₆), et qui reçoit la tension de collecteur du premier transistor (Q₁₅); et une résistance (R₁₈) branchée entre la base du second transistor (Q₁₆) et la masse pour éviter un mauvais fonctionnement du circuit dû à une pointe de courant.

6. Composant mémoir à semi-conducteur selon l'une quelconque des revendications 3, 4 ou 5, dans lequel une diode (D₁₅) destinée à éviter l'inversion du courant est branchée entre l'entrée de commande $\overline{CE}$ et le commutateur sensible à la tension (Q₁₅, Q₁₆, ZD₁₃); et dans lequel un circuit série formé d'une résistance (R₁₆) et d'une diode zéner (ZD₁₂) destiné à éviter un accroisement de la capacité est branché entre la source d'alimentation (V_CC) et le point de connexion entre le commutateur sensible à la tension (Q₁₅, Q₁₆, ZD₁₃) et la diode (D₁₅) empêchant l'inversion du courant.

7. Composant mémoire à semi-conducteur selon l'une quelconque des revendications 3 à 6, dans lequel la tension au-dessus d'un niveau de seuil est une tension issue d'une source de signal qui engendre un signal de validation de puce pendant une opération d'écriture.

8. Composant mémoire à semi-conducteur selon l'une quelconque des revendications 3 à 7, dans lequel la tension la plus élevée injectée seulement dans le circuit de collecteur du transistor de commande (Q₁₃) est la tension appliquée à l'entrée de commande $\overline{CE}$.

# Fig. I

Fig. 2

EP 0 019 381 B1

# Fig. 3

# Fig. 4